# EUROPEAN PATENT APPLICATION

(11) **EP 1 808 992 A1**
(43) Date of publication of application: **18.07.2007**
(21) Application number: 06125324.1
(22) Date of filing: 04.12.2006
(51) Int. Cl.: H04L 29/06

(54) **Method for the exchange of data packets in a network of distributed stations, device for compression of data packets and device for decompression of data packets**

(30) Priority: 13.01.2006 EP 06300031
(71) Applicant: Thomson Licensing S.A., 92100 Boulogne-Billancourt (FR)
(72) Inventor: Zhang, Zhi Gang, Technology Fortune Center, Hai Dian District, 100085 Beijing (CN); Zhang, Huan Qiang, Technology Fortune Center, Hai Dian District, 100085 Beijing (CN); Wang, Charles, Technology Fortune Center, Hai Dian District, 100085 Beijing (CN)
(74) Representative: Schäferjohann, Volker

(57) **Abstract**

The invention is related with network communication, in particular wireless networking. In order to improve bandwidth utilization, a header compression protocol is implemented in most wireless network systems, such as robust header compression ROHC for WLAN systems. When using multicast groups for data communication problems with ROHC are related with relative late initiation of stations that newly enter the multicast group.

The invention proposes an improved state machine for the compressor in order to overcome this drawback.

It is also proposed an improvement for the decompressors which omit sending positive acknowledgements in order to further improve compression efficiency.

The invention also concerns an accordingly improved method for the exchange of data packets in a network of distributed stations.

## Description

### Technical Field

The invention is related to the field of network communication, in particular computer network or home networks. More particularly the invention relates to utilizing data compression for the network communication.

### Background of the Invention

The technique of header compression created by Van Jacobson also called VJHC algorithm and described in RFC 1144 is well established and used to improve the bandwidth usage in a wireless local area network WLAN. It is a data compression protocol specifically designed to improve Transmission Control Protocol / Internet Protocol TCP/IP performance over slow serial links. The header compression technique reduces the normal 40 byte TCP/IP packet headers down to 3-4 bytes for the average case. It does this by saving the state of TCP connections at both ends of a link and only sending the differences in the header fields that change. In a WLAN, header compression can be implemented in access points AP or routers. With the fast deployment of WLANs, it makes sense to use a header compression scheme, specifically ROHC scheme, to reduce the traffic redundancy on the wireless link between WLAN access points - APs and mobile terminals. Currently, the most advanced and commonly used header compression scheme is Robust Header Compression - ROHC. This standardized compression method performs well over links where the packet loss rate is high, such as wireless links. ROHC is standardized in RFC 3095.

While classical ROHC is very suitable for the scenario that there are just one compressor and one decompressor in the network, its feasibility and efficiency is greatly deteriorated when there are one compressor and multiple decompressors in the net, which is a common scenario when the AP delivers multicast streams to the mobile stations under its coverage.

### Invention

When deploying classical ROHC on a WLAN multicast service, its feasibility and efficiency will be deteriorated in the following ways:
□ The new decompressor will be initiated properly long after it joins in the multicast group.
□ The compression efficiency is decreased in the ROHC bidirectional modes, because all decompressors in the multicast group are obliged to send acknowledge packets - ACKs, unacknowledge packets - NACKs and STATIC-NACKs to the compressor.
□ The compressor must take actions accordingly for all acknowledgements and mode transition requests from the different decompressors. It will result in compression state and mode transition conflicts.

Its an object of the invention to solve the problems of the ROHC compression scheme for a wireless networking multicast service.

The problems are solved with the measures in independent claims 1, 12 and 21.

In accordance with one aspect of the invention, an enhancement is proposed when using ROHC Unidirectional Mode to compress a multicast service stream in a wireless network. In addition to the downward state transitions carried out due to timeouts and the need for updates, the compressor also immediately transits back to the initialization state Init-Reset - IR and sends IR updating packets as soon as it recognizes a new decompressor to join the multicast group by monitoring Membership Report messages. This has the advantage that a new decompressor in the multicast group will be initiated immediately. Therefore, the decompressor works properly from the very beginning of its membership. This amendment also results in the decrease of negative acknowledgements traffic caused by the delay of initiation when deploying conventional ROHC Bidirectional Mode in a WLAN multicast application.

Further advantageous embodiments of the invention are disclosed in the dependent claims 2 to 11.

One further improvement consists in an algorithm to coordinate the delivery of IR packets caused by the periodic transition back to IR state and the need for initiating the new decompressor. The transition back period is newly started, when the extra transition to IR state has been performed. This avoids more frequent transitions to IR state and thus more transmissions of update IR packets.

According to another aspect of the invention, an enhanced compression mode - Multicast Enhanced Mode (ME-mode) has been developed for deploying header compression with feedback mechanism in a wireless network multicast service. The key points of this ME mode are as follows:
| The transition logic for compression states in ME mode is based on four principles: the optimistic approach principle, the need for initiation, the need for updates, and negative acknowledgments.
| The decompressor should not send ACKs for successful decompression of updating packets, and the compressor should not expect to get such ACKs either.
| The decompressor transmits an NACK to indicate that the dynamic context of the decompressor is out of sync and a STATIC-NACK to indicate that the static context of the decompressor is not valid or has not been established. Based on the number of received negative acknowledgements - NACKs from different decompressors or the percentage of decompressors sending negative acknowledgements over all decompressors in the multicast group, the compressor will decide if it will transit back to lower compression state immediately.

This improvement has the following advantages:
| Compared with conventional Bidirectional modes, the decompressor doesn't need to send an ACK packet for the successful decompression of an updating packet. It just sends an NACK- or STATIC-NACK-packet to indicate a decompression failure. This measure greatly increases the link usage efficiency.
| By operating in the new ME mode, the transitions between the bidirectional modes of classical ROHC are avoided. In the ME mode, the compressor transits its state based on the amount of the negative acknowledges from multiple decompressors. This avoids the possibility of chaos caused by requesting different compression states and mode transitions from multiple decompressors.

The invention also consists in correspondingly adapted devices for compression of data packets and correspondingly adapted devices for decompression of data packets as disclosed in the claims 12 to 21.

### Drawings

Embodiments of the invention are disclosed in the drawings and will be explained hereinafter. The drawings show in:
- Fig. 1: a typical WLAN surrounding;

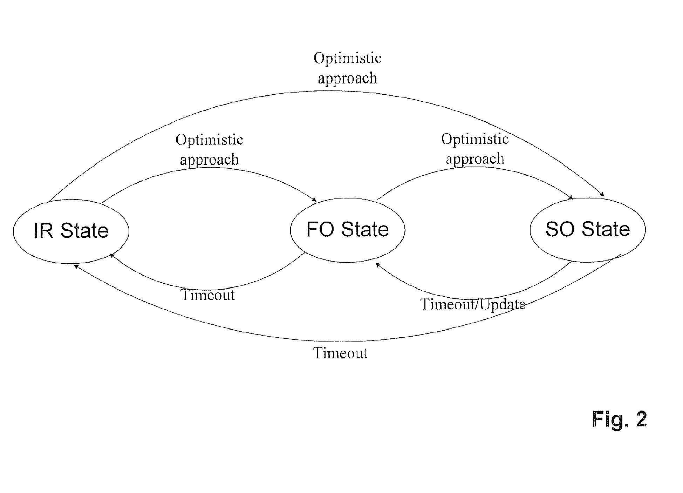

- Fig. 2: a state diagram for a compressor working in classical unidirectional mode;
- Fig. 3: a state diagram for compressor working in the enhanced unidirectional mode;
- Fig. 4: a compressor downward transition flow chart for the enhanced unidirectional mode;
- Fig. 5: a state diagram for the compressor working in Bidirectional Optimistic mode;
- Fig. 6: a state diagram for the compressor working in Bidirectional Reliable mode; and
- Fig. 7: a state diagram for the compressor working in Multicast Enhanced mode;

### Detailed Description of the Invention

In streaming applications, the overhead of Internet Protocol IP, User Datagram Protocol - UDP, and Real Time Transport Protocol - RTP is 40 bytes for IPv4, or 60 bytes for IPv6. For Voice over IP - VoIP this corresponds to around 60% of the total amount of data sent. Such large overheads may be tolerable in wired links where capacity is often not an issue, but are excessive for wireless systems where bandwidth is scarce.

ROHC compresses these 40 bytes or 60 bytes of overhead typically into only 1 or 3 bytes by placing a compressor before the link that has limited capacity and a decompressor after that link. The compressor converts the large overhead to only a few bytes, while the decompressor does the opposite.

The ROHC algorithm is similar to video compression, in that a base frame and then several difference frames are sent to represent an IP packet flow. This has the advantage of allowing ROHC to survive many packet losses in its highest compression state, as long as the base frames are not lost.

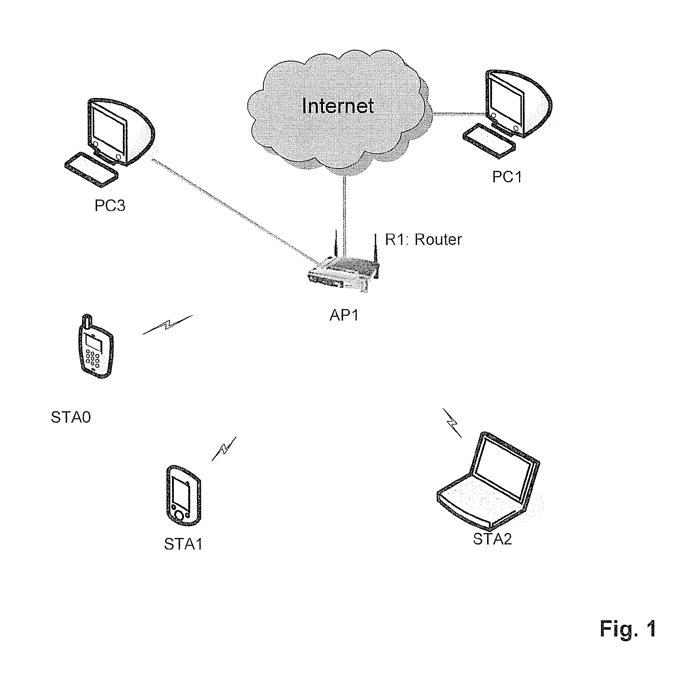

Fig. 1 shows the structure of a typical WLAN at home. A stationary personal computer PC is connected to a WLAN router R1. Also one PDA STA1, a Laptop STA2 as well as a mobile phone STA0 are integrated in the network. The WLAN interface is considered to be IEEE 802.11x compliant. There exist a number of derivates for this system. Well-known ones are IEEE 802.11a-h. The stations in the WLAN have Internet access via the WLAN router R1. All the wireless stations are considered to be ROHC-enabled.

According to RFC 3095 the ROHC scheme has three modes of operation: the Unidirectional, the Bidirectional Optimistic, and the Bidirectional Reliable mode. The invention concerns improvements in each of the three modes.

### ROHC Unidirectional Mode

When a return path from decompressor to compressor is undesirable in WLAN, ROHC operates in the U mode (Unidirectional Mode) and packets are sent in one direction only: from compressor to decompressor. In U mode, transitions between compressor states are performed only on account of periodic timeouts and irregularities in the header field change patterns in the compressed packet stream. Due to the periodic refreshes and the lack of feedback for initiation of error recovery, compression in the U mode will be less efficient and has a slightly higher probability of loss propagation compared to any of the bidirectional modes. The classical state machine for the compressor in unidirectional mode is shown in Figure 1.

An ROHC compressor is in one of 3 main states. In Initialization and Reset - IR state, the compressor has just been created or reset, and full packet headers are sent. In First-Order - FO state, the compressor has detected and stored the static fields (such as IP addresses and port numbers) on both sides of the connection. The compressor is also sending dynamic packet field differences in FO state. Thus, FO state is essentially static + pseudo-dynamic compression. In Second-Order - SO state, the compressor is suppressing all dynamic fields such as RTP sequence numbers, and sending only a logical sequence number and partial checksum to cause the other side to predictively generate and verify the headers of the next expected packet. In general, FO state compresses all static fields and most dynamic fields. SO state is compressing all dynamic fields predictively using a sequence number and checksum.

The size of the sequence number field governs the number of packets that ROHC can lose before the compressor must be reset to continue. The size of the sequence number in 1 and 2 byte ROHC packets is either 4 bits (-1/+14 frame offset), or 6 bits (-1/+62 frame offset), respectively, so ROHC can tolerate at most 62 lost frames with a 1-2 byte header.

The transition logic for compression states in Unidirectional Mode is based on three principles: the optimistic approach principle, timeouts, and the need for updates.

Transition to a higher compression state in unidirectional mode is carried out according to the optimistic approach principle.

For the purpose of recovering form decompression failure, the compressor must periodically transit to lower compression states. Periodic transition to the IR state should be carried out less often than transition to the FO state.

In addition to the downward state transitions carried out due to periodic timeouts, the compressor must also immediately transit back to the FO state when the header to be compressed does not conform to the established pattern.

While this method is suitable for compressing unicast streams without usage of feedback channel, it encounters serious problems when being used in a multicast application in WLAN. Normally, the periodic transition back to IR state in the compressor is set to a long interval so that it can improve the bandwidth efficiency. However, when a mobile station that supports ROHC in WLAN joins the multicast group, it initially enters the No Context state (IR state) and only IR packets, which carry the static information fields, may be decompressed. Then the successful decompression of an IR packet will move the decompressor to the Full Context state (FO state). Otherwise, it will remain in No Context state, ignore and discard all the other types of ROHC packets. In the conventional ROHC Unidirectional Mode, it may take long before the new decompressor receives an IR packet and thus is initiated properly long after it has joined the multicast group. Before then, it can't decompress all packets in the multicast streams. This is totally unacceptable for a WLAN multicast service.

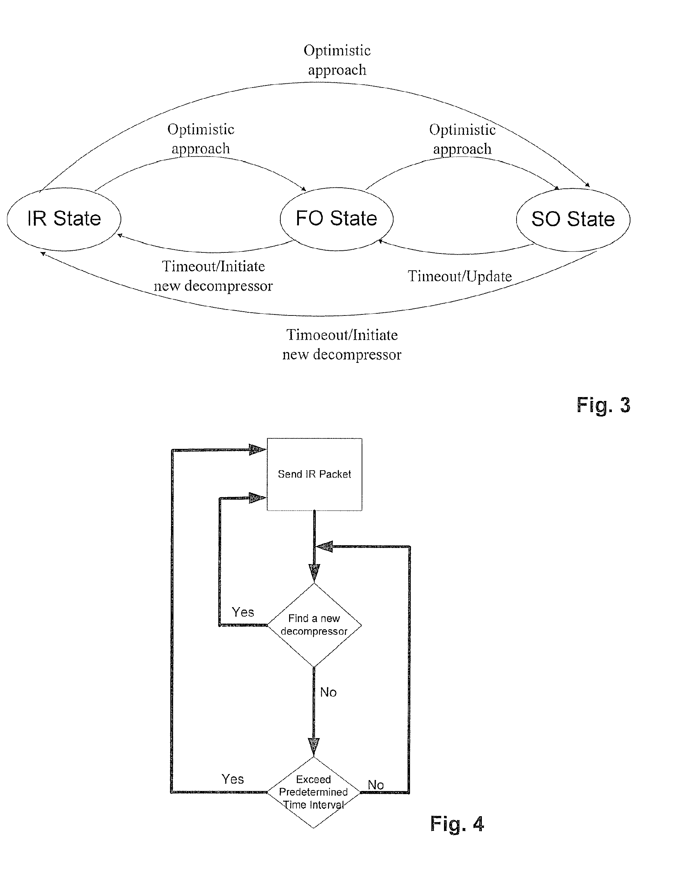

In accordance with the invention, an enhancement for the compressor's state transition scheme in ROHC U mode is invented to solve the problem. The details of state transitions for the enhanced compressor are shown in Fig. 3.

The transition logic for compression states in this enhanced scheme is based on four principles: the optimistic approach principle, timeouts, the need for updates and the need for initiation.

In addition to the downward state transitions carried out due to periodic timeouts and the need for updates in classical U mode, the compressor must also immediately transit back to the IR state and send updating IR packets when it finds a new terminal in its coverage area has joined in the multicast group and is ready to receive a multicast stream. This is true, when the compressor is in FO state or in SO state. The multicast ROHC compressor monitors the IGMP packets to find out if there is a new party to join the multicast group by sending a Membership Report message, and at the same time maintains a timer which lets it periodically transit back to the IR state and send IR refreshing packets. IGMP stands for Internet Group Management Protocol and is used by IP hosts to register their dynamic multicast group membership. It is also used by connected routers to discover these group members. The latest IGMP protocol(IGMPv3) is defined in RFC 3376.

For example, if the time interval for the compressor to periodically transit back to the IR state is set to T, and at T1 the compressor has sent a periodic IR refresh packet, normally the compressor will transit back to IR state and refresh the decompressor at T2=T1+T. However, at one time point T3(T1<T3<T2) during the time interval, the multicast ROHC compressor finds there is an IGMP Membership Report message from a new terminal that indicates a new party has just joined in the multicast group. Then the compressor should transit back to the IR state and send the IR packet immediately so that the new joining decompressor can receive the IR packet and establish the decompression scenario just from the very beginning of its membership. And at the same time, the compressor modifies its state transition plan to schedule it will send the IR refreshing packets at T3+T if there isn't any other party to join the multicast group, instead of sending the IR packets at T2. Fig. 4 is a flow diagram illustrating the described compressor downward transition logic.

### ROHC Bidirectional modes

When there is a feedback channel available and desirable, compression with ROHC starts in the unidirectional mode and then transits to any of the bidirectional modes (O mode or R mode) as soon as a packet has reached the decompressor and it has replied with a feedback packet indicating that a mode transition is desired.

The O mode (Bidirectional Optimistic Mode) is similar to the unidirectional mode. The difference is that a feedback channel is used to send error recovery requests and optionally acknowledgments of significant context updates from decompressor to compressor. Periodic refreshes are not used in the Bidirectional Optimistic Mode.

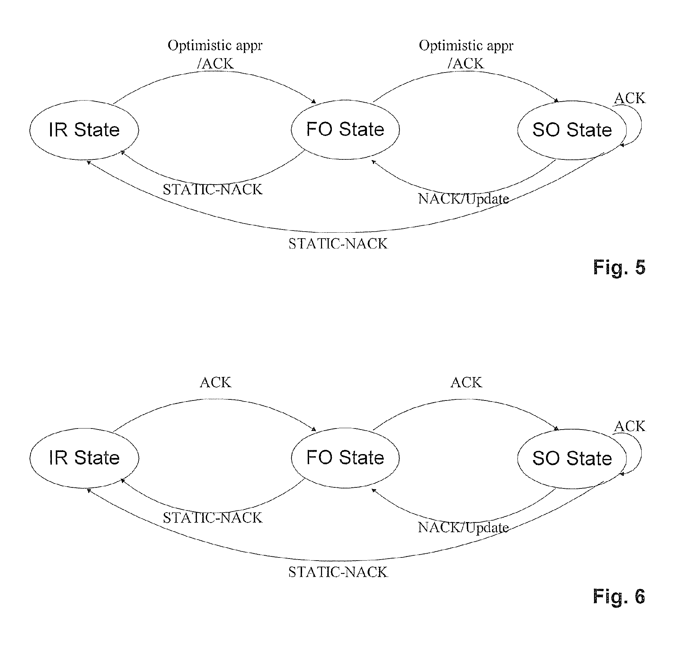

Fig. 5 shows the classical state machine for the compressor in O mode.

The transition logic for compression states in Bidirectional Optimistic Mode has much in common with the logic of the unidirectional mode. However, in optimistic mode there are no timeouts. Instead, the optimistic mode makes use of feedback messages from decompressor to compressor for transitions in the backward direction and for optional improved forward transitions.

For the decompressor, the decompression states and the state transition logic are the same as for the decompression in unidirectional mode. What differs is the decompression and feedback logic. If the optional feedback feature is used once, the decompressor is required to continue to send optional feedback messages for the lifetime of the packet stream.

The R mode (Bidirectional Reliable Mode) differs in many ways from U mode and O mode. The most important differences are a more intensive usage of the feedback channel and a stricter logic at both the compressor and the decompressor that prevents loss of context synchronization between compressor and decompressor except for very high residual bit error rates. Feedback is sent to acknowledge all context updates, including updates of the sequence number field. However, not every packet updates the context in Reliable Mode.

Fig. 6 shows the classical state machine for the compressor in R mode.

The transition logic for compression states in reliable mode is based on three principles: the secure reference principle, the need for updates, and negative acknowledgments.

The upward transition is determined by the secure reference principle. The transition procedure is similar to the U mode, with one important difference: the compressor bases its confidence only on acknowledgments received from the decompressor. This ensures that the synchronization between the compression context and decompression context will never be lost due to packet losses.

Downward transitions are triggered by the need for updates or by negative acknowledgment (NACKs and STATIC-NACKs).

While the bidirectional modes (O mode or R mode) operate perfectly for the unicast application, there do exist some problems if it is used in multicast applications in a WLAN. One problem is that in these two modes, the compressors send IR updating packets only when they receive a STATIC-NACK message from the decompressor. When a new party joins the multicast group, there is no mechanism to ensure that the compressor sends an IR packet to make the newcomers be in synchronisation with the compressor immediately. Without the IR updating packets, the decompressor won't be able to decompress any other ROHC packets and will send back STATIC-NACK messages to the compressor continuously.

Another problem is that after one decompressor sends a positive feedback message to indicate its successful decompression of an update in ROHC Bidirectional Mode, the compressor will expect to receive such packets for the lifetime of packet streams and transits to the higher compression state only after it receives ACK packets for the updates from the decompressor in the future. For the unicast application, because there is only one decompressor, the additional ACK messages won't increase the traffic significantly. But for the multicast service, if all decompressors in the multicast group use ACK messages to exchange information with the compressor, the accumulated ACK messages will reach a large scale and greatly decrease the compression efficiency.

On the other hand, the ROHC compressor will transit back to lower compression state to send the updating packets as soon as it receives an NACK or STATIC-NACK message from the decompressor. For multicast applications in WLAN, the compressor sends the same compressed streams targeted to multiple decompressors. The decompressors's link conditions may be quite different. Using the conventional ROHC mechanism, the compressor will adapt its compression state according to the worst conditions decompressor. In the scenario that many decompressors are connected to the same compressor and only one decompressor's link condition is very bad, the compressor will transit back to lower compression state and send updating multicast packets to all decompressors in the group continuously based on the negative acknowledgements from the worst link condition decompressor. It is unnecessary for the majority in the group and obviates the multicast service philosophy.

The third problem arises as far as mode transition is concerned. Because there are two modes (O mode and R mode) in Bidirectional ROHC Scheme, sometimes the decompressor may change its compression mode. When the mode transition is requested by one decompressor, the compressor will transit to the desired mode. According to this method, in multicast service, if one decompressor sends a mode transition request which asks for the compressor to change to the upward mode (R mode), the compressor will change to the mode accordingly. Thus the two parties will operate in R mode while other decompressors operate in another mode (O mode). It will cause mode synchronization problems for the ROHC compressor and decompressors' operation in multicast service.

In accordance with another embodiment of the invention, one enhanced compression mode - Multicast Enhanced Mode (ME mode) for deploying ROHC with feedback in a wireless network multicast service is proposed to solve the above problems. In such scenario, if the compressor and decompressors decide to use a feedback channel to exchange decompression state information, they will operate in this defined ME mode. The detailed information for the compressor and decompressor are illustrated as follows.

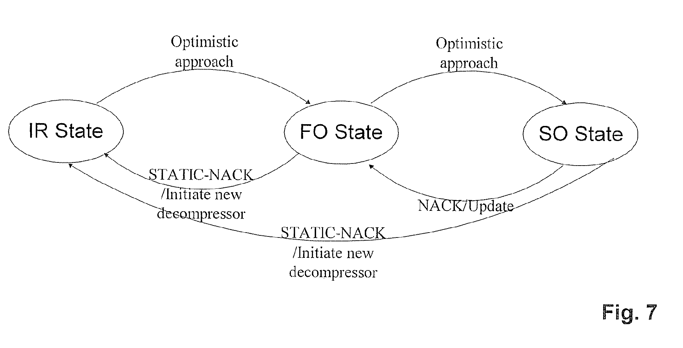

Fig. 7 shows the state machine for the compressor in Multicast Enhanced Mode.

The transition logic for compression states in ME mode is based on four principles: the optimistic approach principle, the need for initiation, the need for updates, and negative acknowledgments.

Transition to a higher compression state in ME mode is carried out according to the optimistic approach principle. This means that the compressor transits to a higher compression state when it is fairly confident that the decompressors have received enough information to correctly decompress packets sent according to the higher compression state.

When the compressor is in the IR state, it will stay there until it assumes that the decompressor has correctly received the static context information. For transition from the FO to the SO state, the compressor should be confident that the decompressor has all parameters needed to decompress according to a fixed pattern. The compressor normally obtains its confidence about decompressors' status by sending several packets with the same information according to the lower compression state. If the decompressor receives any of these packets, it will be in sync with the compressor.

When the optimistic approach is taken as described above, there will always be a possibility of failure since the decompressor may not have received sufficient information for correct decompression and thus send back negative acknowledgments to the compressor. If the number of received NACKs from different decompressors or the percentage of decompressors sending an NACK over all decompressors in the multicast group exceeds a predefined threshold, the compressor will transit back to the FO state and send updates to the decompressors immediately. Similarly, if the number of received STATIC-NACKs from different decompressors or the percentage of decompressors sending a STATIC-NACK over all decompressors in the multicast group exceeds a predefined threshold, the compressor will transit back to the IR state immediately.

Furthermore, the compressor must immediately transit back to the IR state and send IR updating packets when it finds a new terminal in its coverage area has sent an IGMP Membership Report message that indicated it had joined in the multicast group.

In addition to the downward state transitions carried out due to negative acknowledgments and the need for initiation, the compressor must also immediately transit back to the FO state when the header to be compressed does not conform to the established pattern.

In the ME mode, the compressor should not expect to receive ACK messages from the decompressors when sending an updating packet.

The decompression states and the state transition logic are the same as for the existing ROHC O mode case. What differs is the feedback logic.

The existing ROHC feedback logic defines what feedback to send due to different events when operating in the various states. There are three principal kinds of feedback; ACK, NACK and STATIC-NACK. In the ME mode, for the purpose of decreasing additional network traffic, a decompressor does not send an ACK message to the compressor to inform that an updating packet is correctly decompressed. Instead, it will only send negative acknowledgements (NACK and STATIC-NACK) to the compressor. The NACK message indicates that the dynamic context of the decompressor is out of sync, and is generated when several successive packets have failed to be decompressed correctly. The STATIC-NACK message indicates that the static context of the decompressor is not valid or has not been established. NACK is generated when several successive packets have failed to be decompressed correctly. When the static context of the decompressor is not valid, the decompressor moves from SO or FO state to IR state, and sends a STATIC-NACK.

For the purpose of decreasing negative acknowledgements traffic on feedback channel, if the failures continue to emerge, the decompressor may repeat the NACK or STATIC-NACK, but it should not repeat them continuously.

The invention has been explained with state diagrams for the compressor. From the description above, it is evident, that similar state machines with the three states IR, FO, SO are implemented in the decompressors as well.

The use of the invention is not restricted to WLAN systems, it can be used in other wired or wireless networking systems where header compression is utilized as well.

## Claims

1. Method for the exchange of data packets in a network of distributed stations, wherein a data compression protocol is used for compressing the data packets, wherein a compressor comprises a number of states among them an initialization state (IR) with low or none compression of the data packets and at least one compression state (FO, SO) with higher or full compression of the data packets, wherein the compressor sends the compressed packets to one or more decompressors in the network building a multicast group, **characterized in that** the compressor performs a transition back to initialization state (IR) if it is found that a decompressor has newly joined the multicast group.

2. Method according to claim 1, wherein the compressor sends updating initialization packets to the decompressors in the multicast group, after the transition back to initialization state (IR) has been performed.

3. Method according to claim 1 or 2, wherein the compressor performs a step of evaluating membership report messages in order to find out whether a decompressor has joined the multicast group.

4. Method according to claim 3, wherein the compressor performs a step of periodically transiting back to the initialisation state (IR) in order to refresh the one or more decompressors by means of sending new updating initialisation packets.

5. Method according to claim 4, wherein the decompressor performs a step of restarting the timer for periodically transiting back to initialisation state (IR) after the compressor has performed the step of transiting back to initialisation state (IR) due to the fact that a decompressor has newly joined the multicast group.

6. Method according to one of the previous claims, wherein if the compressor and the one or more decompressors of a multicast group are operating in a bi-directional mode in which data packets are sent from compressor to decompressor and feedback packets are sent from the one or more decompressors to the compressor, a decompressor performs a step of omitting positive acknowledgement messages if it has successfully decompressed an updating initialization packet and sends negative acknowledgement messages in case a decompression error has occurred.

7. Method according to claim 6, wherein the compressor performs a step of transiting back to a lower or none compression state (FO, IR) in case the percentage of decompressors in the multicast group from which negative acknowledgement messages have been received exceeds a predefined threshold.

8. Method according to claim 7, wherein the one or more decompressors perform a step of sending two types of negative acknowledgement messages NACK and STATIC-NACK, wherein the NACK message is sent to indicate that the dynamic context of the decompressor is out of synchronization and wherein the STATIC-NACK message is sent to indicate that the static context of the decompressor is not valid or has not been established.

9. Method according to claim 8, wherein the compressor performs a step of transiting back to initialisation state (IR), in case the percentage of decompressors in the multicast group from which the STATIC NACK messages have been received exceeds a predefined threshold.

10. Method according to claim 8 or 9, wherein the compressor performs a step of transiting back to a lower compression state (FO), in case the percentage of decompressors in the multicast group from which the NACK messages have been received exceeds a predefined threshold.

11. Method according to one of the claims 7 to 10, wherein the lower compression state corresponds to the First Order State (FO) of a robust header compression method - ROHC and the none compression state corresponds to the Initialization and Reset State (IR) of the robust header compression method.

12. Device adapted to compressing data packets in a method according to one of the previous claims, comprising means for compressing data packets according to a compression protocol, the device comprising a number of states among them an initialization state (IR) with low or none compression of the data packets and at least one compression state with higher or full compression of the data packets, further comprising means for sending the compressed packets to one or more decompressors building a multicast group in a network of distributed stations, **characterized in that** a state machine in the compressor is adapted to performing a transition back to initialization state (IR) if it is found that a decompressor has newly joined the multicast group.

13. Device according to claim 12, further comprising means for sending updating initialization packets to the decompressors in the multicast group, after the transition back to initialization state (IR) has been performed.

14. Device according to claim 12 or 13, further comprising means for receiving and evaluating membership report messages from decompressors in order to find out whether a decompressor has newly joined the multicast group.

15. Device according to one of claims 12 to 14, further comprising a timer for the state machine that periodically controls the device to transit back to the initialisation state (IR) in order to refresh the one or more decompressors by means of sending new updating initialisation packets.

16. Device according to claim 15, further comprising means for restarting the timer for the state machine after the device has performed the transition back to initialisation state (IR) due to the fact that a decompressor has newly joined the multicast group.

17. Device according to one of claims 12 to 16, further comprising means for receiving and evaluating feedback messages such as acknowledgement or negative acknowledgement messages from the one or more decompressors, and wherein the state machine in the compressor is adapted to performing a transition back to a lower or none compression state (FO, IR) if it is found that the percentage of decompressors in the multicast group from which negative acknowledgement messages have been received exceeds a predefined threshold.

18. Device according to claim 17, said means for evaluating feedback messages being adapted to evaluate at least two types of negative acknowledgement messages NACK and STATIC-NACK, wherein the NACK message is sent by a decompressor to indicate that the dynamic context of the decompressor is out of synchronization and wherein the STATIC-NACK message is sent by a decompressor to indicate that the static context of the decompressor is not valid or has not been established, said state machine being adapted to performing a transition back to initialisation state (IR), in case the percentage of decompressors in the multicast group from which the STATIC NACK messages have been received exceeds a predefined threshold.

19. Device according to claim 17 or 18, wherein said state machine is adapted to performing a transition back to a lower compression state (FO), in case the percentage of decompressors in the multicast group from which the NACK messages have been received exceeds a predefined threshold.

20. Device according to one of the claims 12 to 19, wherein the lower compression state corresponds to the First Order State (FO) of a robust header compression method - ROHC and the none compression state corresponds to the initialization state (IR) of the robust header compression method.

21. Device adapted to decompressing data packets in a method according to one of the claims 1 to 11, comprising means for decompressing data packets, the device being adapted to operate in a bi-directional mode in which data packets are sent from compressor to decompressor and feedback packets are sent back from the one or more decompressors to the compressor, **characterized, in that** the device is adapted to omitting sending back positive acknowledgement messages if it has successfully decompressed an updating initialization packet and the device is adapted to sending negative acknowledgement messages in case a decompression error has occurred.
